Europäisches Patentamt

(19) European Patent Office

Office européen des brevets

(11) Publication number: **0 210 454 B1**

# EUROPEAN PATENT SPECIFICATION

(12)

(45) Date of publication of patent specification :
**30.01.91 Bulletin 91/05**

(51) Int. Cl.⁵: **G11C 8/00**

(21) Application number: **86108939.9**

(22) Date of filing : **01.07.86**

(54) **Memory circuit with improved word line noise preventing circuits.**

(30) Priority : **01.07.85 JP 145033/85**

(43) Date of publication of application :
**04.02.87 Bulletin 87/06**

(45) Publication of the grant of the patent :
**30.01.91 Bulletin 91/05**

(84) Designated Contracting States :
**DE FR GB**

(56) References cited :
**WO-A-81/03570**
**DE-A- 3 307 756**
**GB-A- 2 102 645**

(56) References cited :
**IEEE JOURNAL OF SOLID-STATE CIRCUITS,
vol. SC-19, no. 5, October 1984, pages 602-609,
IEEE, New York, US; E.K. BAIER et al.: "A fast
256K DRAM designed for a wide range of
applications"**

(73) Proprietor : **NEC CORPORATION
7-1, Shiba 5-chome Minato-ku
Tokyo 108-01 (JP)**

(72) Inventor : **Morita, Yasukazu
NEC Corporation 33-1, Shiba 5-chome
Minato-ku Tokyo (JP)**

(74) Representative : **Glawe, Delfs, Moll & Partner
Patentanwälte
Postfach 26 01 62 Liebherrstrasse 20
D-8000 München 26 (DE)**

## Description

The present invention relates to a dynamic memory circuit employing field effect transistors, and more particularly to a word line noise preventing circuit for preventing word lines from being affected by noise or the like according to the preamble part of claim 1.

Dynamic memories have been widely utilized in various fields because of large memory capacity and relatively low power consumption. In dynamic memories, word lines are driven in dynamic manner. Namely, all word lines are reset to the ground potential in reset (or precharge) period and in active period selected one word line is driven to a power voltage (Vcc) through a source-follower transistor while the remaining non-selected word lines are left in floating state. In other words, the non-selected lines are not connected to any voltage source in active period. Therefore, the non-selected word lines are easily affected by noise such as voltage change in digit lines. Particularly, rise of potential of digit lines having higher level (logic 1 level) to the power voltage Vcc by active pull up circuits raise the potential of the non-selected word lines. In this case, many memory cells which should not be selected are erroneously accessed so that a plurality of stored data are simultaneously read out to the each digit line, resulting in destruction of memory data stored in the memory cells.

In order to avoid the above problem due to the fluctuation in the potentials of the non-selected word lines, word line noise preventing circuits are provided to the respective word lines. The word line noise preventing circuit maintains the potential of the non-selected word line at the ground potential during active period. Such a noise preventing circuit is disclosed in G3-A-2102 645 which shows a memory circuit according to the preamble part of claim 1.

On the other hand, half the digit lines which have been charged to a precharge voltage such as the power voltage through reset period are discharged to the ground potential by amplifying operation of sense amplifiers.

The discharge of the digit lines affects the potential of the substrate on which a memory is fabricated and potentials of memory cell capacitors through coupling therebetween so that the potentials of the substrate and the memory cell capacitors are lowered.

Especially, in the memory cell storing logic "0" level, i.e. the ground potential, the potential of the memory cell capacitors is lowered from the ground potential to a negative potential, and in the case where such negative potential is lower than the ground potential which is applied to the non-selected word lines by, a threshold voltage of memory cell transistors, the memory cell transistors having gates coupled to the non-selected word lines become conducting. Thus, in addition to the memory cell transistors coupled to the selected word line, the memory cell transistors coupled to the non-selected word lines are erroneously, rendered conductive, which means in other words a plurality of data from a plurality of memory cells are read out on the same digit line at the same time. Accordingly, data stored in these memory cells are destroyed due to mutual interference.

From WO-A-81/03570 noise preventing circuits are known in which a plurality of quiet line flip-flops are provided. These flip-flops share the same precharge transistor so that a higher integration density can be obtained. Due to this particular structure all flip-flops are disabled when one of the wordlines is once selected. Therefore, sufficient noise preventing function cannot be expected.

In DE-A-33 07 756 a memory circuit having a plurality of pull-down circuits for wordline noise prevention is disclosed. In this circuit, the commonly connected source electrodes of transistors of the pull-down circuits are connected to a voltage line provided with a negative potential. However, it is necessary to provide a special voltage generating circuit for generating the negative potential in this known memory.

It is therefore the object of the invention to provide a memory circuit which has a simple construction and which can operate stably without causing data destruction or malfunction.

This object is achieved by a memory circuit having the features given in claim 1; the dependent claims are related to further developments of the invention.

According to this features, the word line noise prevention circuits are disabled during the amplifying period by the sense amplifiers so that the clamping of the non-selected word lines is released. Accordingly, the non-selected word lines are allowed to be affected by the discharge of the digit lines so that the potential of the non-selected word lines are lowered below the reference voltage as well as the fall of the potentials of the memory cell capacitors. Therefore, the gate-source potential of the memory cell transistors connected to the non-selected word lines is not increased thereby to prevent the memory cell transistors coupled to the non-selected word lines from assuming conductive during the period when the sense amplifiers discharge the digit lines. Thus, data destruction can be effectively avoided.

The memory circuit is further provided with a plurality of active pull-up circuits each coupled to each pair of digit lines for operatively raising the higher potential side digit line to the power voltage after the amplification by the sense amplifier, and the word line noise preventing circuit is enabled at least the period when the active pull-up circuit operates.

The word line noise preventing circuit according to the present invention is composed of a first field effect transistor having a current path connected between a first node and a reference potential source, a series circuit of second and third field effect transistors connected in series between one of the word lines and the reference potential source, the first and second transistors forming a flip-flop circuit, and a precharge transistor for operatively precharging the first node, the third transistor controlling the noise preventing circuit between the enabled state and the disenabled state.

## BRIEF DESCRIPTION OF THE DRAWINGS :

Fig. 1 is a schematic circuit diagram showing a major part of a memory circuit according to a prior art ;

Fig. 2 is a timing chart showing operation of the memory circuit of Fig. 1 ;

Fig. 3 is a schematic circuit diagram showing a major part of a memory circuit according to one embodiment of the present invention ;

Fig. 4 is a timing chart showing operation of the circuit in Fig. 3 ; and

Fig. 5 is a schematic diagram showing another embodiment of the invention :

## DETAILED DESCRIPTION OF THE INVENTION :

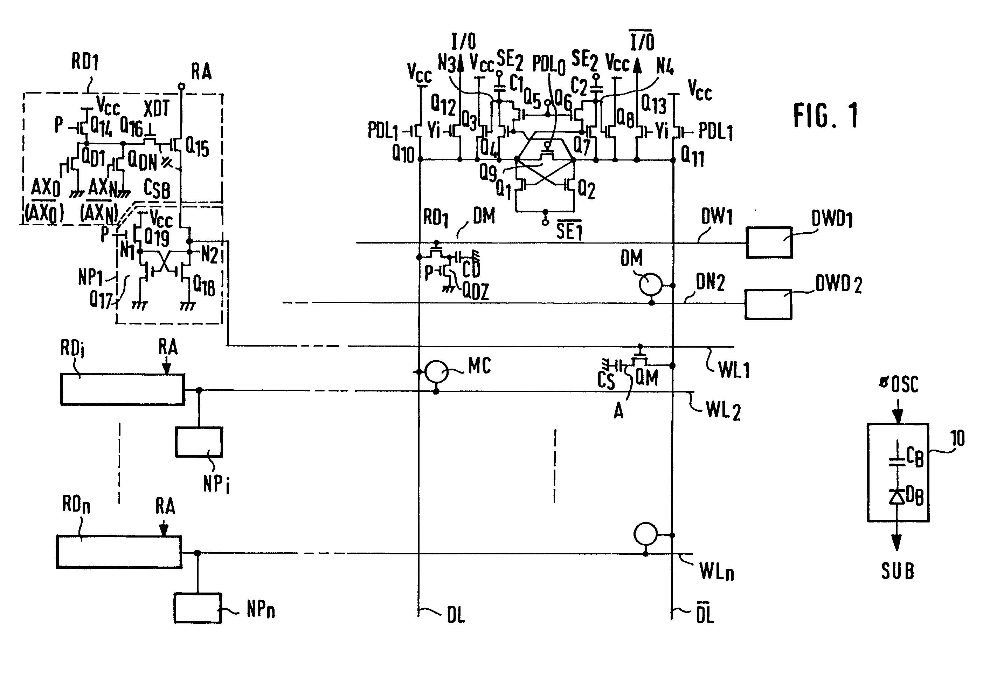

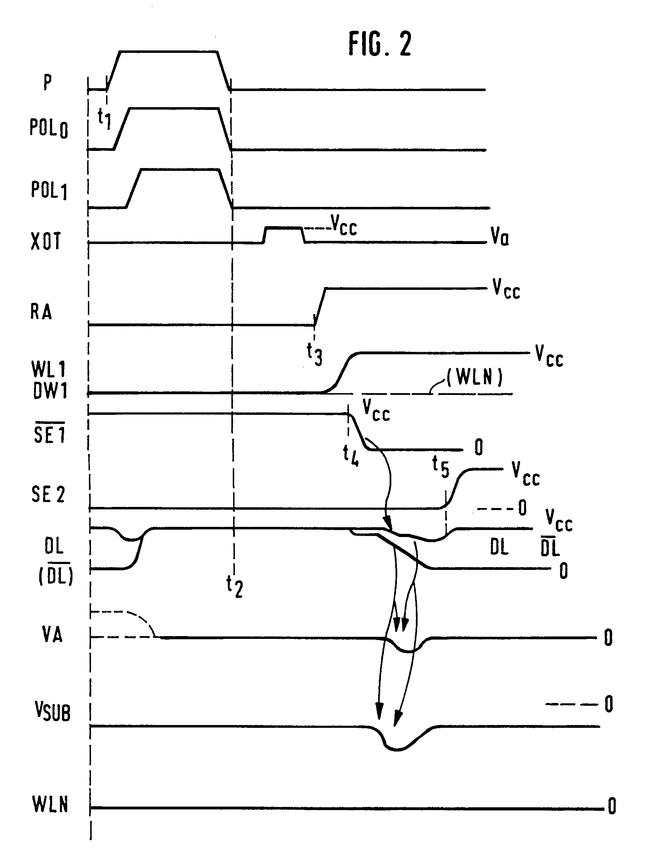

With reference to Figs. 1 and 2, a memory circuit according to a prior art is explained.

Fig. 1 shows a major part of a conventional dynamic memory circuit.

A pair of digit lines DL and $\overline{DL}$ are arranged in parallel, while a pair of dummy word lines $DW_1$ and $DW_2$ and a plurality of word lines $WL_1$ to $WL_n$ are intersecting with the digit lines DL and $\overline{DL}$. Dummy cells DM consisting of FETs $Q_{D1}$ and $Q_{D2}$ and a capacitor $C_D$ are connected to the dummy word lines $DW_1$, $DW_2$ and the digit lines DL, $\overline{DL}$ while memory cells MC each composed of a cell FET $Q_M$ and a memory cell capacitor $C_S$ are connected to the word lines $WL_1$ to $WL_n$ and the digit lines DL and $\overline{DL}$, in a known way. In Fig. 1, among many pairs of digit lines, one pair of digit lines DL and $\overline{DL}$ are representatively illustrated.

FETs $Q_1$ and $Q_2$ form a flip-flop type sense amplifier. FETs $Q_3$ to $Q_8$ and capacitors $C_1$ and $C_2$ form an active pull-up circuit which raises a potential of the higher side digit line to a power voltage Vcc after the operation of the sense amplifier.

FETs $Q_9$ to $Q_{11}$ form a precharge circuit for equally precharging the digit lines DL and $\overline{DL}$ to Vcc.

FETs $Q_{12}$ and $Q_{13}$ are coupled between the digit lines DL, $\overline{DL}$ and a pair of bus lines I/O, $\overline{I/O}$, respectively to make data-transfer therebetween when FETs $Q_{12}$ and $Q_{13}$ are rendered conductive by a column selection signal Yi.

The word lines $WL_1$ to $WL_n$ are selected row decoders $RD_1$ to $RD_n$, respectively. The row decoder $RD_1$ is composed of a source-follower FET $Q_{17}$ con-

nected in series between a timing signal source RA and the word line $WL_1$, a NOR circuit having FETs $Q_{D1}$ to $Q_{DN}$ receiving row address signals $AX_0$ $(\overline{AX_0})$ to $AX_n$ $(\overline{AX_n})$ and a precharge FET $Q_{14}$, and a transfer FET $Q_{16}$ for connecting an output of the NOR circuit to a gate of FET $Q_{15}$.

Other word decoders $WD_2$ to $WD_n$ have the same structure except a combination of address signals $AX_0$, $\overline{AX_0}$ to $Ax_n$, $\overline{AX_n}$ applied thereto. Word line noise preventing circuits $NP_1$ to $NP_n$ are connected to the word lines $WL_1$ to $WL_n$, respectively.

The word line noise preventing circuit $NP_1$ is composed of a pair of FETs $Q_{17}$ and $Q_{18}$ forming a flip-flop circuit, a drain (N2) of FET $Q_{18}$ being connected to the word line $WL_1$, and a precharge FET $Q_{19}$ for precharging a node $N_1$ to Vcc. A substrate bias circuit 10 is formed on the same semiconductor chip on which the memory circuit is fabricated. The circuit 10 receives an oscillation signal $\emptyset_{osc}$ to generate a substrate bias $(V_{SUB})$ through a capacitor $C_B$ and a diode $D_B$ to be applied to the substrate SUB in a known way.

Fig. 2 shows operation of the circuit of Fig. 1. At a time point $t_1$, the previous access cycle is terminated and a reset period is initiated.

A reset precharge signal P is first raised to Vcc to render FETs $Q_{14}$ in each row decoder, $Q_{19}$ in each noise preventing circuit and $Q_{D2}$ in each dummy memory cell. Thus, the dummy cells DM and the row decoders are reset for subsequent operations. Also in each noise preventing circuits, the node $N_1$ is charged to Vcc to render FET $Q_{18}$ conductive so that the word line connected to that noise preventing circuit is clamped to the ground potential.

Subsequently, timing signals $PDL_0$ and $PDL_1$ are sequentially raised to Vcc so that the digit lines DL and $\overline{DL}$ are equally precharged to Vcc and the capacitors $C_1$ and $C_2$ are also precharged to Vcc through FETs $Q_5$ and $Q_6$.

At a time $t_2$, the timing signals P, $PDL_0$ and $PDL_1$ are fallen to the ground potential to terminate the reset period and introduce an active period.

Subsequently, in the active period, after the respective address signals $AX_0$ $(\overline{AX_0})$ to $AX_n$ $(\overline{AX_n})$ have established their logical states, a control signal XDT is raised to Vcc so that the gate potential of FET $Q_{15}$ is determined by the output of the NOR circuit in each row decoder. Then, after the gate potential of FET $Q_{15}$ has been determined, the signal XDT is reduced to an intermediate voltage which is lower than Vcc but higher than a threshold voltage of FET $Q_{16}$.

Then the timing signal RA having Vcc is applied to the drain of FET $Q_{15}$ in each row decoder at a time $t_3$. In this instance, the signal RA is transmitted through the row decoder in which the gate potential of FET $Q_{15}$ is high in level to a selected word line (e.g. $WL_1$) to set it approximately at Vcc.

In this instance, in the word line noise preventing circuit e.g. $NP_1$, since the current capability of FET $Q_{19}$

is set smaller than that of FET $Q_{15}$, the potential at the node $N_2$ is raised to discharge the node N1. Thus, FET $Q_{18}$ becomes non-conducting so that the selected word line e.g. $WL_1$ is raised to Vcc. While in the remaining noise preventing circuits (e.g. $NP_2$ to $NP_n$), the charge at the node $N_1$ is maintained without being discharged to keep FET $Q_{18}$ conductive. Thus, the non-selected word lines (e.g. $WL_2$ to $WL_n$) are clamped to the ground potential so that fluctuation in potential of the non-selected word lines can be effectively avoided. In response to this selection of word line $WL_1$, data stored the capacitor $C_S$ in the memory cell MC coupled to the selected word line is transferred onto the digit line e.g. $\overline{DL}$. Also, the dummy word line e.g. $DW_1$ is simultaneously driven to Vcc by the decoder $DWD_1$ to connect the capacitor $C_D$ to the digit line DL so that a slight change in potential is applied to DL. The change caused by the dummy cell is of an intermediate degree between the cases caused by the memory cells storing "1" and "0".

Subsequently, at a time $t_4$, a sense enable signal $\overline{SE_1}$ is fallen from Vcc to the ground potential. In response to this, the sense amplifier ($Q_1$, $Q_2$) starts to discharge the lower potential side digit line (e.g. DL) without materially discharging the high potential side digit line (e.g. $\overline{DL}$), thus discriminating the pair of digit lines into binary logic levels. In this instance, the discharge of the lower potential side digit lines makes the substrate bias voltage $V_{SUB}$ and the potential $V_A$ at the output node A of the memory cell capacitor $C_S$ in each of memory cells lower through coupling between the digit lines and the substrate and the cell capacitors $C_S$, as illustrated. Especially for those memory cells storing "0" level, the potential $V_A$ is fallen to a negative potential.

While the non-selected word lines are kept at the ground potential as explained above. Accordingly, in the case where the fall of the potential $V_A$ at the node A is larger than a threshold voltage of the memory cell transistor $Q_M$ in the memory cells storing "0" level, the memory cell transistor $Q_M$ is forward-biased to take conductive state even though the word line connected thereto is of the non-selected (ground) level. Accordingly, a plurality of data stored in a plurality of memory cells are read out on to the same digit line in this case so that data of the memory cells are destroyed due to mutual interference among a plurality of memory cells.

The above fall in potentials of the substrate and the memory cell capacitors gradually recovers to return to their initial potentials due to supply of charge to the substrate from the substrate bias circuit 10.

Subsequently, at a time $t_5$, the active pull-up circuits start their operations in response to a rise of a timing signal SE 2. Particularly, in the case where DL and $\overline{DL}$ are at "0" and "1" level, respectively, FET $Q_4$ is conducting and hence the potential at a node $N_3$ is discharged to the ground potential so that FET $Q_3$

becomes non-conductive state, while FET $Q_7$ is not conductive so that the rise of SE 2 is superposed on the previously charged level (Vcc) at a node $N_2$ so that the potential at the node $N_4$ becomes above Vcc thereby to render FET $Q_8$ in the non-saturated conductive state. Accordingly, the potential of the higher potential digit line $\overline{DL}$ is raised to Vcc through FET $Q_8$.

As explained above, the discharge of the lower potential digit lines affects the memory cells, resulting in malfunction.

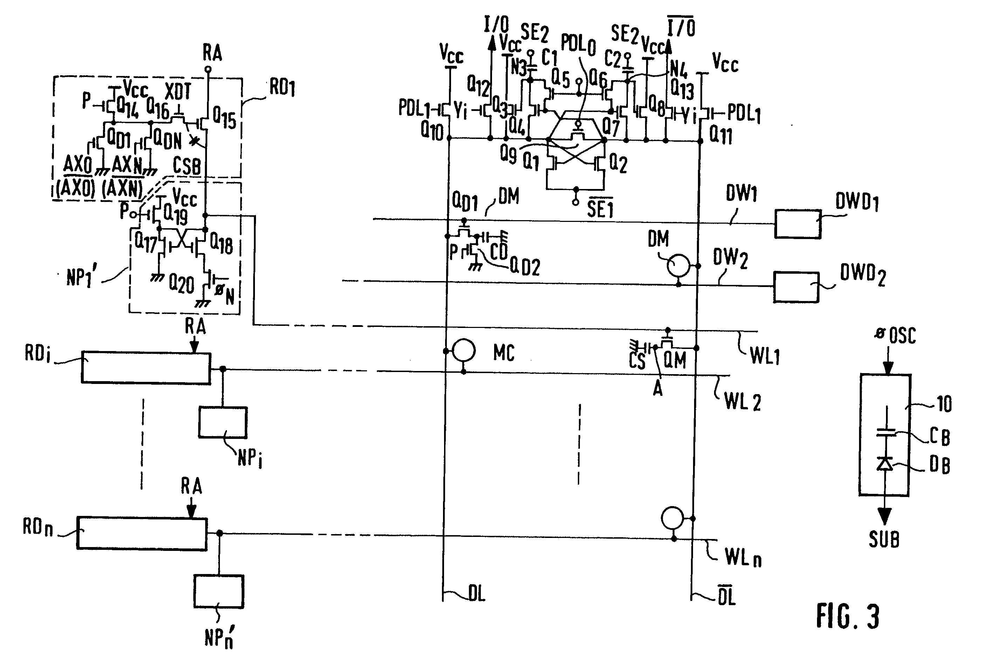

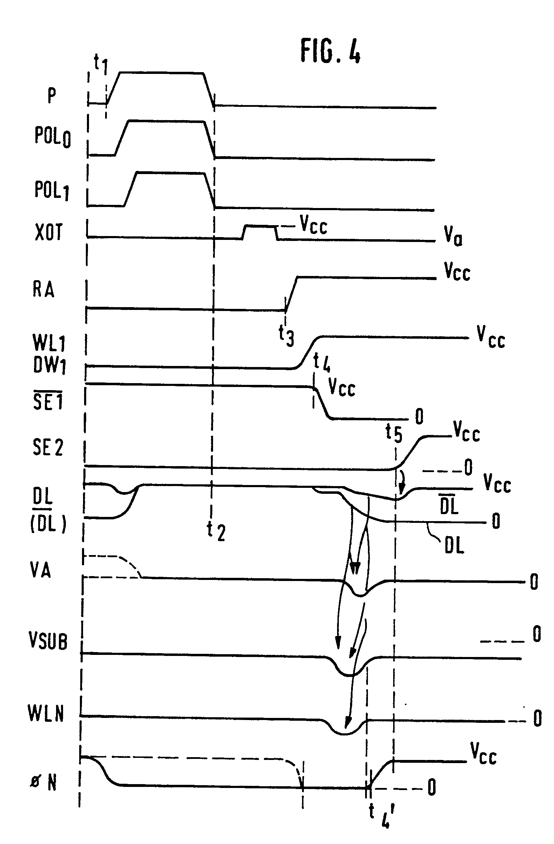

Referring to Figs. 3 and 4, a memory circuit according to one embodiment of the invention is described. In Figs. 3 and 4, elements corresponding to those in Figs. 1 and 2 are designated by the same references.

This embodiment is achieved by employing word line noise preventing circuits $NP_1'$ to $NP_n'$ in place of the circuits $NP_1$ to $NP_n$ in Fig. 1. The word line noise preventing circuit $NP_1'$ is composed of a series connection of FETs $Q_{18}$ and $Q_{20}$ connected between the word line $WL_1$ the ground potential, FET $Q_{17}$ connected between the precharge node $N_1$ and the ground potential and forming a flip-flop with FET $Q_{17}$ and a precharge FET $Q_{19}$. A control signal $\emptyset_N$ is applied to a gate of FET $Q_{20}$. When the signal $\emptyset_N$ is high (Vcc) in level, EFT $Q_{20}$ is conductive thereby to enable the noise preventing circuit $NP_1'$. While $\emptyset_N$ is low (GND) in level, FET $Q_{20}$ is non-conductive thereby to disenable the circuit $NP_1'$. The other noise preventing circuits $NP_2'$ to $NP_n'$ have the same construction as $NP_1'$.

The signal $\emptyset_N$ is rendered low in level when the sense amplifiers discharge the lower potential side digit lines so that the noise preventing circuits $NP_1'$ to $NP_n'$ are disenabled. Accordingly, the non-selected word lines are not clamped to the ground potential but laid floating state. After discharge of the digit lines by the sense amplifiers and during the period when the active pull-up circuits are enabled thereby to raise the higher potential side digit lines approximately to Vcc, the signal $\emptyset_N$ is made high to enable the noise preventing circuits $NP_1'$ to $NP_n'$. Therefore, the non-selected word lines are clamped to the ground potential without being affected by the rise of the higher potential side digit lines by the active pull-up circuits.

The operation of this embodiment is explained with reference to Fig. 4.

The operation from the time point t1 to the time t4 is the same as that of the circuit of Fig. 1 except the noise preventing circuits. Namely, during this period from t1 to 64, the signal $\emptyset$N assumes the low level (GND) to render FET Q20 non-conductive in each of the noise preventing circuits. Therefore, the noise preventing circuits NPi t NPn' are disenabled so that the non-selected word lines are laid in floating state. Subsequently, at a time t4, the signal SE1 is fallen from Vcc to the ground potential so that the sense amplifiers start their amplification operations, under the disenabled state of the noise preventing circuits. Accordingly, the lower potential side digit lines are discharged. In response to the discharge of the digit lines, the substrate bias voltage VSUB and the potential VA of the memory cell capacitors Cs storing "0" level are lowered to negative values, respectively. However, in this instance the noise preventing circuits NPi to NPn' are disenabled and therefore, the potential of the non-selected word lines are also lowered to a negative potential due to coupling between the substrate and the word lines.

Accordingly, even when the potential VA of the memory cell capacitor Cs is lowered to a negative value, the gate potential of the memory cell transistor QM coupled to the non-selected word line is simultaneously lowered to a negative value, as illustrated, and therefore, the memory cell transistor QM can be kept at non-conducting state. Accordingly, destruction of stored data and/or mutual interference among memory cells can be effectively avoided.

Subsequently, after the potential of the non-selected word line WLN, the substrate bias voltage VSUB and the potential VA of the memory cell capacitor CS return to their predetermined values at a time t4', the signal øN is raised to VCC thereby to enable the noise preventing circuits NPi t NPn'. Accordingly, the non-selected word lines are clamped to the ground potential. Then, at a time t5, the signal SE2 is raised to Vcc and the active pull-up circuits are enabled. Thus, the higher potential side digit lines are raised to Vcc by the pull-up circuit. The side of the higher potential side digit lines affect the non-selected word lines so as to raise their potentials. However, in this instance, the non-selected word lines are clamped to the ground potential by the noise preventing circuits, such affection can be effectively avoided.

As to the waveform of øN, it is also possible to maintain it at high during the period from t1 to t4 as illustrated by dotted line.

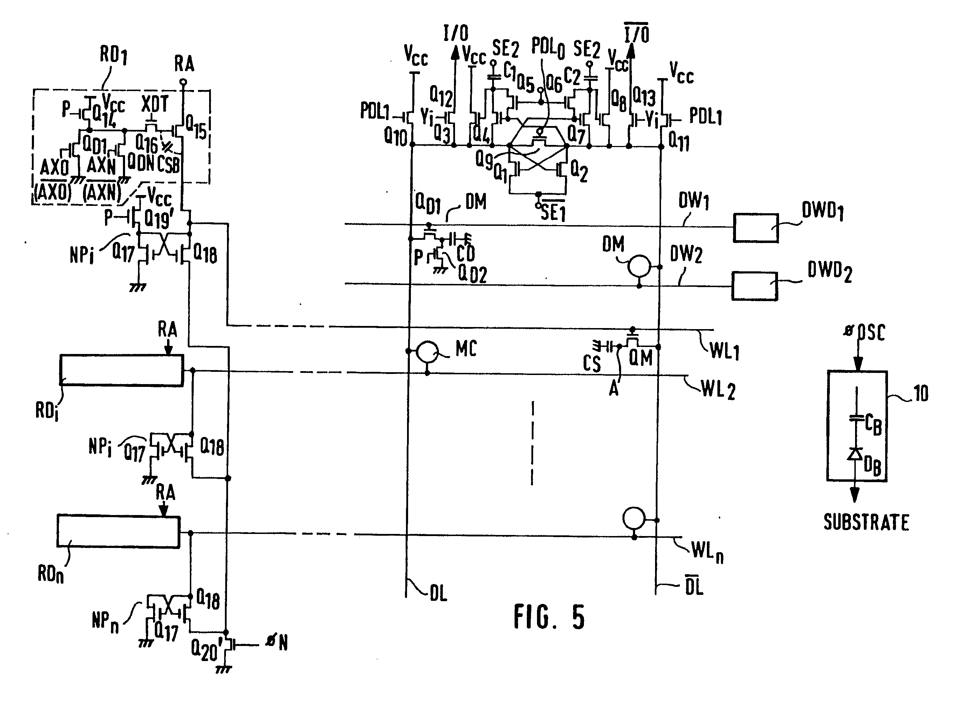

Fig. 5 shows another embodiment of the invention. This embodiment is featured in that FET Q20 receiving øN and the precharge FET Q19 in Fig. 3 are commonly provided as FETs Q20' and Q19' for a plurality of noise preventing circuits NP1" to NPn". According to this feature, the size of each noise preventing circuit can be reduced to enhance high density structure of a memory circuit.

## Claims

1. A memory circuit comprising at least a pair of digit lines (DL, $\overline{DL}$) a plurality of word lines (WL1-WLn) intersecting with said pair of digit lines, a plurality of memory cells (MC) coupled to said digit lines and said word lines, a word line selection circuit (RD1-RDn) for selecting one of said word lines, a sense amplifier (Q1, Q2) operatively discharging one line of said pair of digit lines during a first period (t4-t4'), a pull-up circuit (Q3-Q8) for operatively raising the potential of the other line of said pair of digit lines during a second period (t5-) after said first period, a plurality of word line noise preventing circuits (NP1-NPn), each of said noise preventing circuits operatively clamping the associated word line in the case when said associated word line is not selected, each of said noise preventing circuits including a first node (N2) coupled to the associated word line, a second node (N1), a first transistor (Q18) having a gate coupled to said second node, first means for coupling a source-drain path of said first transistor between said first node and a reference voltage terminal (GND), a second transistor (Q17) having a gate coupled to said first node and a source-drain path coupled between second node and said reference voltage terminal, and a third transistor (Q19) coupled to said second node for operatively precharging said second node thereby to render said first transistor conductive, CHARACTERIZED in that said memory circuit further comprises control means (øN, Q20) for disenabling said noise preventing circuits during said first period thereby to isolate the respective first nodes from said reference voltage terminal and enabling said noise preventing circuits during said second period.

2. The memory circuit according to claim 1, CHARACTERIZED in that said control means includes a plurality of switch elements (Q20), each of said switch elements having a switched current path inserted in series with respect to the source-drain path of the first transistor (Q18) of each one of said word line noise preventing circuits.

3. The memory circuit according to claim 1, in which said memory circuit is formed on a semiconductor substrate (SUB), CHARACTERIZED in that said memory circuit further comprises a substrate bias circuit (10) for biasing said substrate at a predetermined potential.

## Ansprüche

1. Speicherschaltung mit zumindest einem Paar Ziffernzeilen (DL, $\overline{DL}$), einer Vielzahl von Wortzeilen (WL1-WLn), die sich mit dem Paar Ziffernzeilen schneiden, einer Vielzahl von Speicherzellen (MC), die mit den Ziffernzeilen und den Wortzeilen gekoppelt sind, einer Wortzeilenauswahlschaltung (RD1-RDn) zum Auswählen einer der Wortzeilen, einem Leseverstärker (Q1, Q2), der im Arbeitszustand eine Zeile des Ziffernzeilenpaares während einer ersten Periode (t4-t4') ausgibt, einer Erregerschaltung (Q3-Q8), um im Arbeitszustand das Potential der anderen Zeile des Ziffernzeilenpaares während einer zweiten Periode (t5-), nach der ersten Periode, anzuheben, einer Vielzahl von Wortzeilenrauschunterdrückungsschaltungen (NP1-NPn), wobei jede der Wortzeilenrauschunterdrückungsschaltungen im Arbeitszustand die assoziierte Wortzeile in dem Fall anklammert, in dem die assoziierte Wortzeile nicht ausgewählt ist, wobei jede der Rauschunterdrückungsschaltungen einen ersten Knoten (N2), der mit der assoziierten Wortzeile gekoppelt ist, einen zweiten Knoten (N1), einen ersten Transistor (Q18) mit einem Tor, das mit dem zweiten Knoten gekoppelt ist, eine erste Einrichtung, um einen Source-Drain-Weg des ersten Transistors zwischen dem ersten Knoten und einem Bezugsspannungsanschluß (GND) zu koppeln, einen zweiten Transistor (Q17) mit einem Tor, das an den ersten Knoten und an einen Source-Drain-Weg gekoppelt ist, der zwischen dem zweiten Knoten und dem Bezugsspannungsanschluß gekoppelt ist, und einen dritten Transistor (Q19), der mit dem zweiten Knoten gekoppelt ist, um im Arbeitszustand den zweiten Knoten vorzuladen und dadurch den ersten Transistor leitend zu machen, umfaßt, dadurch **gekennzeichnet**, daß die Speicherschaltung ferner eine Steuereinrichtung (øN, Q20) zum Deaktivieren der Rauschunterdrückungsschaltungen während der ersten Periode, um dadurch die jeweiligen ersten Knoten von dem Bezugsspannungsanschluß zu isolieren, und zum Aktivieren der Rauschunterdrückungsschaltungen während der zweiten Periode umfaßt.

2. Speicherschaltung nach Anspruch 1, dadurch **gekennzeichnet**, daß die Steuereinrichtung eine Vielzahl von Schaltelementen (Q20) umfaßt, wobei jedes der Schaltelemente einen geschalteten Stromweg aufweist, der in Bezug zu dem Source-Drain-Weg des ersten Transistors (Q18) jeder der Wortzeilenrauschunterdrückungsschaltungen in Reihe geschaltet ist.

3. Speicherschaltung nach Anspruch 1, in der die Speicherschaltung auf einem Halbleiterträger (SUB) ausgebildet ist, dadurch **gekennzeichnet**, daß die Speicherschaltung ferner einen Trägervorspannungskreis (10) umfaßt, um an den Träger ein vorbestimmtes Potential anzulegen.

**Revendications**

1. Circuit de mémoire comprenant au moins une paire de lignes de chiffres (DL, $\overline{DL}$), une paire de lignes de mots (WL1-WLn) en intersection avec ladite paire de lignes de chiffres, une pluralité de cellules mémoires (MC) reliées auxdites lignes de chiffres et auxdites lignes de mots, un circuit de sélection de lignes de mot (RD1-RDn) pour sélectionner l'une desdites lignes de mots, un amplificateur de lecture ($Q_1$, $Q_2$) déchargeant, en mode actif, une ligne de ladite paire de lignes de chiffres lors d'une première période ($t_4$-$t_{4'}$), un circuit d'excitation ($Q_3$-$Q_8$) pour faire croître, en mode actif, le potentiel de l'autre ligne de ladite paire de lignes de chiffres lors d'une seconde période

($t_5$-$t_{5'}$) après ladite première période, une pluralité de circuits de prévention de bruit dans des lignes de mots (NP$_1$-NP$_n$), chacun desdits circuits de prévention de bruit verrouillant, en mode actif, la ligne de mots associée dans le cas où ladite ligne de mots associée n'est pas sélectionnée, chacun desdits circuits de prévention de bruit comportant un premier noeud (N2) relié à ladite ligne de mots associée, un second noeud (N1), un premier transistor ($Q_{18}$) ayant une grille reliée audit second noeud, un premier moyen pour relier un trajet source-drain dudit premier transistor entre ledit premier noeud et une borne de tension de référence (GND), un second transistor ($Q_{17}$) ayant une grille reliée audit premier noeud et un trajet source-drain relié entre ledit second noeud et ladite borne de tension de référence, et un troisième transistor ($Q_{19}$) relié audit second noeud pour précharger, en mode actif, ledit second noeud afin de rendre conducteur ledit premier transistor, CARACTERISE en ce que ledit circuit de mémoire comprend en outre des moyens de commande (øN, $Q_{20}$) pour désactiver lesdits circuits de prévention de bruit lors de ladite première période afin d'isoler les premiers noeuds respectifs de ladite borne de tension de référence et pour activer lesdits circuits de prévention de bruit lors de ladite seconde période.

2. Circuit de mémoire selon la revendication 1, CARACTERISE en ce que ledit moyen de commande comporte une pluralité d'éléments commutateurs ($Q_{20}$), chacun desdits éléments commutateurs ayant un trajet de courant commuté inséré en série par rapport au trajet source-drain du premier transistor ($Q_{18}$) de chacun desdits circuits de prévention de bruit.

3. Circuit de mémoire selon la revendication 1, dans lequel ledit circuit de mémoire est formé sur un substrat semi-conducteur (SUB), CARACTERISE en ce que ledit circuit de mémoire comporte en outre un circuit de polarisation de substrat (10) pour polariser ledit substrat à un potentiel prédéterminé.

FIG. 1

EP 0 210 454 B1

FIG. 2

FIG. 3

# FIG. 4

FIG. 5